# EUROPEAN PATENT SPECIFICATION

(11) **EP 0 777 270 B1**
(45) Date of publication and mention of the grant of the patent: **23.04.2003**
(21) Application number: 95830499.0
(22) Date of filing: 30.11.1995
(51) Int. Cl.: H01L 23/40

(54) **Heat dissipator for electronic devices**
Wärmeableiter für elektronische Anordnungen
Dissipateur de chaleur pour dispositifs électroniques

(43) Date of publication of application: 04.06.1997
(73) Proprietor: STMicroelectronics S.r.l., 20041 Agrate Brianza (Milano) (IT)
(72) Inventor: Poinelli, Renato, I-22064 Casatenovo (Como) (IT)
(74) Representative: Botti, Mario

(56) References cited:
- EP-A- 0 484 180
- EP-A- 0 554 500
- EP-A- 0 619 605
- DE-U- 9 409 045
- DE-U- 9 417 497
- DE-U- 29 500 423
- GB-A- 2 184 887
- US-A- 5 367 433
- PATENT ABSTRACTS OF JAPAN vol. 14 no. 213 (E-923) ,7 May 1990 & JP-A-02 049457 (MITSUBISHI ELECTRIC CORP) 19 February 1990,

## Description

### Field of application

The present invention relates to a combination of a semiconductor electronic device and heat sink. Specifically the present invention relates to a combination of a semiconductor electronic device, of the type having a plastic body incorporating a metal plate leaving bare a major surface area, with a heat sink comprising means of fastening to the electronic device in contact with the bare surface of the plate.

The present invention also relates to a combination of a semiconductor electronic device comprising an integrated circuit associated with a metallic plate and a synthetic-plastic body partially or completely incorporating the metallic plate, and a heat sink comprising a base in heat-conductive contact with the metallic plate and formed in a single body from which extend a series of cooling fins, wherein the device exhibits undercut zones on opposite sides and the sink comprises two elastic elements extending from opposite sides of the base and designed to engage in a removable manner with the undercut zones of the electronic device.

### Prior art

The sink provided in accordance with the present invention can be coupled with different types of electronic devices but is described specifically in combination with a container or 'package' for surface mounting on medium power integrated circuits.

As known, an integrated circuit is provided on a chip of semiconductor material having a few square millimeters of surface area for connecting it to an external circuit, e.g. a circuit printed on a plate of insulating material which is a special support structure for containment and electrical interconnection. A known structure suited for the purpose consists essentially of a plastic body enclosing the chip which is connected through thin metallic wires welded on special metallized areas provided on its surface to corresponding electrical terminal conductors, or pins, emerging from the plastic body.

In the case of integrated power circuits, i.e. devices designed to operate with relatively high currents and therefore subject to considerable heating, these structures also include a metallic plate through which the chip, which is fixed thereto, can transfer out the heat produced during operation.

When the heat to be dissipated is relatively little or when a broad metallic surface is available on the board for dissipation, the pins are bent so as to have the bare surface of the plate in contact with the board and specifically with a metallic area on which the plate is welded during the same welding step as that of the pins.

When the heat to be dissipated is more or it is not desired or not possible to use a broad area of the board for heat dissipation, the pins are bent in the opposite direction and a bigger sink is applied to the bare surface of the plate which, in this case, is located on the face opposite that of contact with the board.

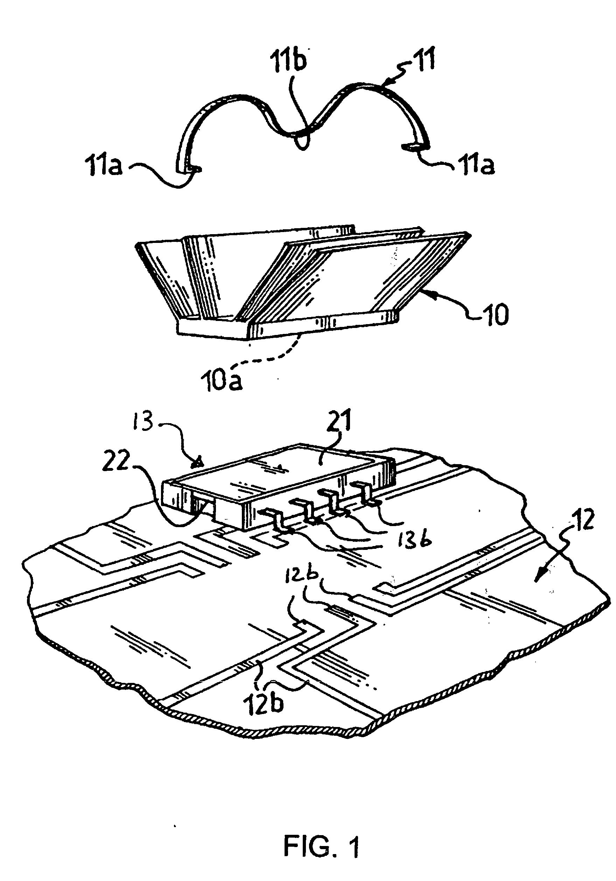

This last situation is shown in FIG. 1 of the drawings annexed to the present description and described in detail in European Patent Application filed by SGS-THOMSON Microelectronics s.r.l. published under number 0619605 on 12 October 1994. For fastening the sink, which bears reference number 10, there is used an elastic clip 11 having a central part 11b pushing the sink 10 centrally towards the bare surface of the plate 21 and having the ends 11a bent inward in such a manner as to engage with two undercut zones 22 of the plate 21.

Assembly of the various parts making up the combination of the device 13 and the sink 10 of FIG. 1 takes place by first fixing the device 13 to the board 12 through welding of its pins 13b to the metallic areas 12b and then resting the sink 10 with one of its flat surfaces 10a on the bare surface of the metallic plate 21 of the device 13 and finally applying the clip 11 by deforming it elastically until its ends 11a snap into the undercut internal areas 22 of the metallic plate 21. Disassembly of the sink takes place by appropriately deforming the clip 11 in such a manner as to disengage it from the undercut zones 22.

This assembly combination exhibits however shortcomings. Specifically if assembly of the electronic components on the printed circuit board takes place automatically, the step of fastening the sink on the device cannot take place automatically. Indeed, it would be complicated for normal machines for assembling components on cards in a single operation to hold the sink in position on the device and at the same time apply the elastic clip.

### Summary of the invention

The solution idea underlying the present invention is to conceive a heat sink produced preferably by an extrusion process and easy to couple to an electronic device through fastening means incorporated in the sink by simply applying pressure without using additional fastening systems.

On the basis of the above solution idea the technical problem is solved by a combination of a semiconductor electronic device with a heat sink of the type indicated and defined in the characterizing part of claims 1 to 4.

In particular, the combination of a semiconductor electronic device (2) comprising an integrated circuit associated with a metallic plate (9) and a heat sink includes two elastic elements (8) extending from opposite sides of the base (11) and designed to engage in a removable manner with the undercut zones (6) of the electronic device (2), characterized in that each elastic element includes a first portion that extends vertically from the base in a manner similar to the cooling fins, a second portion that bends back into a U-shape from the first portion, a third portion extending from the U-shape virtually parallel to the first portion, with a space between the first and third portions, and a fourth portion extending from the third portion and having a first surface that extends inwardly for engagement with the undercut zones when the heat sink is fully in place on the electronic device and a second surface that extends downwardly and outwardly from the first surface and in that said undercut zones are formed by at least two bare edge areas formed on the opposite side of the metallic plate to said bare surface of the metallic plate.

The characteristics and advantages of the combination of a semiconductor electronic device with a heat sink in accordance with the present invention are set forth in the description of an embodiment thereof given below by way of non-limiting example with reference to the annexed drawings.

### Brief description of the drawings

FIG. 1 shows an enlarged perspective view of detached parts of the known combination of an electronic device, a sink and fastening means described above,
FIG. 2 shows a front view of a combination of an electronic device and a sink in accordance with the present invention,
FIG. 3 shows a side view of the same combination of an electronic device and a sink shown in FIG. 2, and
FIG. 4 shows an extruded bar from which are separated by means of a special tool the individual sinks produced in accordance with the present invention.

### Detailed description

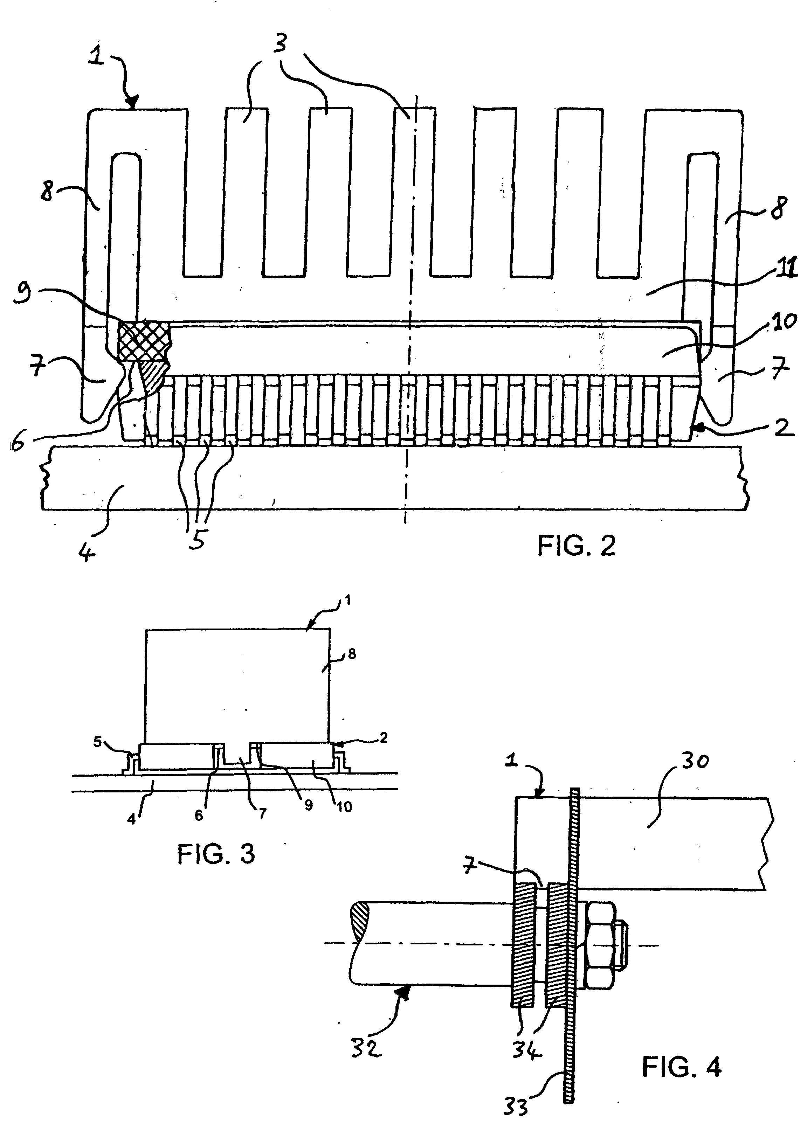

A combination of a semiconductor electronic device 2 and a heat sink 1 in accordance with the present invention is shown in FIG. 2.

The electronic device 2 is structurally similar to the known device 13 shown in FIG. 1 and exhibits a plastic body 10 incorporating a metallic plate 9 while leaving bare a greater surface area parallel to the terminal support surface and two edge areas 6 on the surface opposite the bare surface. The plate 9 is in heat-conducting contact with a semiconductor chip inside the device and not visible in FIG. 2 and in which is integrated a circuit. Two series of electrical contact terminals indicated by reference number 5 are connected through thin gold wires inside the device to special pads on the chip and protrude from opposite sides of the body 10. These terminals 5 exhibit a double bend such that their ends appear on the same plane as the device assembly surface on a printed circuit board 4. The two bare edge areas 6 of the plate constitute in this case two undercut zones which in accordance with the present invention are used for fastening of a heat sink 1.

The heat sink 1 is made up of a single block of metallic material and preferably a metal which is a good heat conductor such as aluminum or copper and is made in this embodiment by separation from a metal bar obtained by an extrusion process in accordance with a process described below.

The sink comprises a base 11 which is mounted on the plate 9 of the device 2 from which extend a series of cooling fins 3. The heat generated by the chip during operation is transmitted through the plate 9 to the sink base 11 and spreads into the cooling fins 3.

For optimal heat dissipation it is necessary that the sink 1 be kept in close contact with the device 2. Advantageously the sink 1 includes fastening means designed to hold the two elements closely joined.

In accordance with the present invention the two fastening means are two elastic elements 8 in a single piece with the base 11 and which extend on two opposite sides of the sink and exhibit hook-shaped ends 7 which engage with the undercut zones of the plate 9. To have good elasticity these elements develop in two distinct portions for a total length approximately double the length of the cooling fins 3.

A first portion develops vertically from the base with shape and dimensions similar to those of the cooling fins 3 to then bend back in a U and develop in a second portion virtually parallel to the first portion. The second portion has a width equal to the width of the first portion but in this embodiment is thinner than the cooling fins 3.

The end of the second portion exhibits a tooth 7 narrower than the second portion and having a projection opposite the undercut zone 6 of the plate 9. When the sink 1 'is applied to the device 2 this projection, thanks to the elasticity of the element 8, engages in a removable manner with the undercut zone 6 to hold the device and sink tightly joined.

FIG. 3 shows a side view of the combination of an electronic device 2 and a sink 1 in accordance with the present invention. In particular there is seen the device 2 fastened by means of its terminals 5 on the printed circuit board 4 and the sink 1 fastened to the device 2 by means of the elastic elements 8. In the device 2 can be noted the synthetic-plastic body 10, a visible part of the plate 9 and the undercut zone 6 of the plate 9. The visible part of the sink 1 is the second portion of one of the elastic elements 8 having at its end the tooth 7 engaged with the undercut zone 6 of the plate 9.

Assembly of the various parts making up the combination in accordance with the present invention takes place in a very simple manner by setting the sink on the device and applying pressure on the top of the dissipator so that the two elastic elements 8 are elastically deformed until their ends or teeth-7 snap into the undercut zones 6 of the plate 9 of the device 2.

Disassembly of the sink takes place by appropriately deforming the two elastic elements 8 in such a manner as to disengage the teeth 7 from the undercut zones 6.

There is now described a process by which it is possible to make a heat sink provided in accordance with the present invention.

By means of a hot extrusion process which is known and amply used in aluminum processing and in particular in the production of heat sinks there is obtained an extruded bar having a cross section equal to the cross section desired for the sinks which will then be made by separation from the above mentioned bar.

An aluminum bar obtained by this process is shown in FIG. 4 and indicated by number 30. From this bar 30 a sink 1 is separated by means of a cutter 32. In particular. the cutter 32 is a tool having multiple disks 33, 34 fixed on the same axis with a first thin disk 33 which cuts the sink from the bar 30 while two other disks 34 which are wider and of smaller diameter than the first disk 33 grind part of the sink to form the two teeth 7 on the elastic elements 8. By using a tool 32 of the type described the two operations of cut-off and milling of the part being machined take place simultaneously.

The complexity and duration of the operation are thus comparable with respect to the machining times of aluminum sinks and it is also possible to use normal machinery for extrusion and machining of the metals.

The material used for production of the sink in the embodiment described here is aluminum but another metal could be used provided it is a good heat conductor and extrudable as for example copper.

There is obtained in this manner a structure capable of great heat sink which requires the same printed circuit board surface area occupation required for a device without external sink and which does not require for assembly the use of external elements such as the clip used in the known combination shown in FIG. 1. In addition the sink provided in accordance with the present invention can be readily applied on the electronic device during automatic assembly of the components on the printed circuit board using normal machines for assembly of components.

It is also important to point out that the combination in accordance with the present invention does not require manufacture of specific electronic devices for its practical implementation but allows use of devices manufactured with the same dies used for manufacturer of devices designed to be assembled with the metallic plate in contact with the surface of the board and hence without an external heat sink, or in combination with a sink of known type equipped with a separate elastic clip such as that shown in FIG. 1 and described above.

Naturally the present invention is applicable with the same advantages to devices which are even considerably different from that shown provided they exhibit on opposite sides adjacent to the bare surface of the plate recesses or grooves constituting undercut zones for anchoring the fastening means incorporated in the sink.

## Claims

1. Combination of a semiconductor electronic device (2) comprising an integrated circuit associated with a metallic plate (9) and a synthetic-plastic body (10) partially or completely incorporating the metallic plate (9) whereby the metallic plate (9) has a bare surface forming part of the external surface of the device (2), and a heat sink (1) comprising a base (11) in heat-conductive contact with the metallic plate. (9) and formed in a single body from which extend a series of cooling fins (3), wherein the device (2) has undercut zones (6) on opposite lateral sides and the heat sink (1) comprises two elastic elements (8) extending from opposite sides of the base (11) and designed to engage in a removable manner with the undercut zones (6) of the electronic device (2), **characterized in that** each elastic element includes a first portion that extends vertically from the base in a manner similar to the cooling fins, a second portion that bends back into a U-shape from the first portion, a third portion extending from the U-shape virtually parallel to the first portion, with a space between the first and third portions, and a fourth portion (7) extending from the third portion and having a first surface that extends inwardly for engagement with the undercut zones when the heat sink is fully in place on the electronic device and a second surface that extends downwardly and outwardly from the first surface and **in that** said undercut zones are formed by at least two bare edge areas formed on the opposite side of the metallic plate to said bare surface of the metallic plate.

2. Combination in accordance with claim 1, **characterized in that** the heat sink (1) is provided in a single extruded metal block.

3. Combination in accordance with claim 2, **characterized in that** the heat sink (1) is provided in aluminum alloy.

4. Combination in accordance with claim 2, **characterized in that** the heat sink (1) is provided in copper alloy.

## Patentansprüche

1. Kombination einer elektronischen Halbleitervorrichtung (2), umfassend eine integrierte Schaltung, die mit einer metallischen Platte (9) verbunden ist, und einem Synthetik-Kunststoff-Körper (10), der die metallische Platte (9) teilweise oder vollständig aufnimmt, wodurch die metallische Platte (9) eine blanke Oberfläche hat, die einen Teil der Außenfläche der Vorrichtung (2) bildet, und eine Wärmesenke (1) mit einer Basis (11), die sich in wärmeleitendem Kontakt mit der metallischen Platte (9) befindet und in einem einzelnen Körper ausgebildet ist, von dem aus sich eine Reihe von Kühlrippen (3) erstreckt, wobei die Vorrichtung (2) unterschnittene Zonen (6) an gegenüberliegenden lateralen Seiten aufweist und die Wärmesenke (1) zwei elastische Elemente (8) umfasst, die sich von gegenüberliegenden Seiten der Basis (11) aus erstrecken und so gestaltet sind, dass sie mit den unterschnittenen Zonen (6) der elektronischen Vorrichtung (2) entfernbar eingreifen, **dadurch gekennzeichnet, dass** jedes elastische Element einen. ersten Bereich, der sich senkrecht von der Basis in einer ähnlichen Weise wie die Kühlrippen erstreckt, einen zweiten Bereich, der sich von dem ersten Bereich in einer U-Form zurück erstreckt, einen dritten Bereich, der sich von der U-Form praktisch parallel zum ersten Bereich erstreckt, wobei ein Abstand zwischen dem ersten und dritten Teil vorhanden ist, und einen vierten Bereich (7) aufweist, der sich von dem dritten Bereich erstreckt und eine erste Fläche, die sich nach innen zum Eingriff mit den unterschnittenen Zonen erstreckt, wenn die Wärmesenke vollständig auf der elektronischen Vorrichtung angebracht ist, und eine zweite Fläche hat, die sich von der ersten Fläche aus nach unten und außen erstreckt, und dass die unterschnittenen Zonen durch mindestens zwei blanke Randbereiche gebildet werden, die an der gegenüberliegenden Seite der metallischen Platte zu der blanken Oberfläche der metallischen Platte angeformt ist.

2. Kombination nach Anspruch 1, **dadurch gekennzeichnet, dass** die Wärmesenke (1) in einem einzelnen extrudierten Metallblock vorgesehen ist.

3. Kombination nach Anspruch 2, **dadurch gekennzeichnet, dass** die Wärmesenke (1 in Aluminiumlegierung vorgesehen ist.

4. Kombination nach Anspruch 2, **dadurch gekennzeichnet, dass** die Wärmesenke (1) in Kupferlegierung vorgesehen ist.

## Revendications

1. Combinaison d'un dispositif électronique à semi-conducteurs (2) comprenant un circuit intégré associé à une plaque métallique (9) et un corps en plastique synthétique (10) intégrant une partie ou l'ensemble de la plaque métallique (9), moyennant quoi la plaque métallique (9) présente une surface nue faisant partie de la surface externe du dispositif (2), et un dissipateur thermique (1) comprenant une base (11) en contact thermo-conducteur avec la plaque métallique (9) et formé sous la forme d'un corps unique à partir duquel s'étend une série d'ailettes de refroidissement (3), dans lequel le dispositif (2) présente des zones de gravures sous-jacentes (6) sur les faces latérales opposées (8) et le dissipateur thermique (1) comprend deux éléments élastiques (8) s'étendant depuis les faces opposées de la base (11) et étant conçus pour venir en prise d'une manière amovible avec les zones de gravures sous-jacentes (6) du dispositif électronique (2), **caractérisé en ce que** chaque élément élastique comprend une première partie qui s'étend verticalement depuis la base d'une manière similaire aux ailettes de refroidissement, une deuxième partie qui est recourbée pour obtenir une forme de U à partir de la première partie, une troisième partie s'étendant depuis la forme de U sensiblement parallèlement à la première partie, avec un espace entre les première et troisième parties, et une quatrième partie (7) s'étendant depuis la troisième partie et présentant une première surface qui s'étend vers l'intérieur pour venir en prise avec les zones de gravures sous-jacentes lorsque le dissipateur thermique est complètement en place sur le dispositif électronique et une deuxième surface qui s'étend vers le bas et vers l'extérieur à partir de la première surface et **en ce que** lesdites zones de gravures sous-jacentes sont formées par au moins deux zones de bords nus sur la face opposée de la plaque métallique par rapport à ladite surface nue de la plaque métallique.

2. Combinaison selon la revendication 1, **caractérisée en ce que** le dissipateur thermique (1) est prévu en un seul bloc métallique extrudé.

3. Combinaison selon la revendication 2, **caractérisée en ce que** le dissipateur thermique (1) est réalisé dans un alliage d'aluminium.

4. Combinaison selon la revendication 2, **caractérisée en ce que** le dissipateur thermique (1) est réalisé dans un alliage de cuivre.
